# EUROPEAN PATENT APPLICATION

(11) **EP 1 231 192 A1**
(43) Date of publication of application: **14.08.2002**
(21) Application number: 01301107.7
(22) Date of filing: 08.02.2001
(51) Int. Cl.: C04B 35/475, C04B 35/468, H01L 41/187

(54) **Lead-free piezoelectric ceramic materials**

(71) Applicant: NGK SPARK PLUG CO., LTD, Mizuho-ku Nagoya-shi Aichi (JP)
(72) Inventor: Takase, Masanori, Inazawa-shi, Aichi (JP); Ohbayashi, Kazushige, Nagoya, Aichi (JP)
(74) Representative: West, Alan Harry

(57) **Abstract**

The invention provides a lead-free piezoelectric ceramic material having a large piezoelectric strain constant with low temperature dependence. The material includes Ba, Bi, Na, Ti and O and, on a molar basis satisfies 0,99 < Bi/Na ≤ 1,01 and Ba/Bi = 2x/(a-x), in which 0.99 ≤ a ≤ 1.01 and 0 < x < a.

## Description

This invention relates to piezoelectric ceramic materials. More particularly, the invention relates to lead-free piezoelectric ceramic materials which have a large piezoelectric strain constant and whose piezoelectric strain constant exhibits low dependence on temperature. The piezoelectric ceramic materials of the invention can be employed for producing piezoelectric devices such as oscillators, actuators, sensors and filters.

The majority of conventional mass-produced piezoelectric ceramic materials contain lead and/or lead oxide, such as PT (lead titanate) and PZT (lead titanate zirconate). However, firing of such lead-containing piezoelectric ceramic materials necessarily involves evaporation of lead oxide and similar substances. The treatment of lead and lead compounds without exerting adverse environmental effects involves high costs among other disadvantages. Therefore, there has been keen demand for realization of lead-free piezoelectric ceramic materials. Recently, (Bi_{0.5}Na_{0.5})TiO₃ (referred to as "BNT") and bismuth-lamellar compounds have become of interest in this context. However, compared with lead-containing piezoelectric ceramic materials, such a lead-free material has a low piezoelectric strain constant, the strain is small with respect to applied voltage and the voltage generated from the material is small with respect to applied stress. Use of such a lead-free piezoelectric ceramic material therefore encounters difficulties when attempts are made to apply the material as an active element such as an oscillator.

Japanese Patent Publication (*kokoku*) No. 4-60073 describes a piezoelectric ceramic material containing BNT. This publication describes a new composition of lead-free piezoelectric ceramic material. However, the piezoelectric strain constant of the material is 99 X 10⁻¹² C/N at most. Although the publication is silent about temperature dependence of the piezoelectric strain constant, the piezoelectric strain constant temperature coefficient of a piezoelectric ceramic material must be almost zero in order for the material to exhibit consistent performance over a wide temperature range.

The present invention seeks to solve the problems outlined above, and to provide lead-free piezoelectric ceramic materials having large piezoelectric strain constants which exhibit low temperature dependence.

In accordance with the invention, there is provided a piezoelectric ceramic material containing Ba, Bi, Na, Ti, and O, which on a molar basis satisfies 0.990 < Bi/Na ≤ 1.01 and Ba/Bi = 2x/(a-x), in which 0.99 ≤ a ≤ 1.01 and 0 < x < a.

When the Bi/Na and Ba/Bi ratios fall outside the above ranges, the piezoelectric strain constant of the material tends to be small.

The piezoelectric ceramic materials of the invention are preferably represented by the formula xBaTiO₃-(a-x)(Bi_{b}Na_{c})TiO₃. Preferably, such piezoelectric ceramic materials are solid solutions and have a perovskite-type structure. However, the ceramic materials may have a structure including a perovskite phase as a primary crystalline phase. The ceramic materials may have a structure including other crystalline phases, so long as the phases do not impair the piezoelectric characteristics of the materials. In the above formula, b and c satisfy the relationship 0.990 < b/c ≤ 1.01.

In the above formula, x is preferably from 0.05 to 0.5, inclusive. When x is less than 0.05 or in excess of 0.5, the piezoelectric strain constant of the piezoelectric ceramic materials tends to be lower. The lower limit of x is determined to be 0.05, since the morphotropic phase boundary may exist in the vicinity of the composition in which x = 0.05 to 0.06. Therefore, when x is less than 0.05, the piezoelectric strain constant of the piezoelectric ceramic materials decreases drastically, and obtaining a large piezoelectric strain constant (170 X 10⁻¹² C/N or more) may therefore be difficult.

In the above formula, x is more preferably from 0.1 to 0.5, inclusive, much more preferably from 0.2 to 0.5, inclusive. When x falls within the above range, an especially large piezoelectric strain constant can be obtained. In addition, temperature dependence of the piezoelectric strain constant can be reduced. When x falls within the above range, the resultant compositions contain a large amount of barium titanate as a solid solution, as compared with the compositions in which the morphotropic phase boundary exists.

When x falls within the above preferred range, the piezoelectric ceramic materials have a piezoelectric strain constant at 20°C (d₃₃^{20°C}) as measured according to EMAS-6100 (standards by Denshi Zairyo Kogyokai), of 100 X 10⁻¹² C/N or more (usually 170 X 10⁻¹² C/N or less, preferably 100 X 10⁻¹² to 160 X 10⁻¹² C/N, more preferably 110 X 10⁻¹² to 160 X 10⁻¹² C/N) and a piezoelectric strain constant temperature coefficient (d₃₃t), which is calculated on the basis of formula (1) by use of d₃₃^{20°C} and d₃₃^{80°C} (the piezoelectric strain constant at 80°C), of 0.15 %/°C or less (usually 0.05 %/°C or more, preferably 0.08 to 0.12 %/°C, more preferably 0.08 to 0.11 %/°C).

The values d₃₃^{20°C} and d₃₃t can be attained simultaneously. Briefly, when d₃₃^{20°C} is 100 X 10⁻¹² C/N or more (usually 170 x 10⁻¹² C/N or less), d₃₃t is 0.15 %/°C or less (usually 0.05 %/°C or more). The piezoelectric ceramic materials more preferably have d₃₃^{20°C} of 105 X 10⁻¹² to 150 X 10⁻¹² C/N and d₃₃t of 0.05 to 0.14 %/°C, much more preferably d₃₃^{20°C} of 110 X 10⁻¹² to 135 X 10⁻¹² C/N and d₃₃t of 0.08 to 0.12 %/°C.

The piezoelectric ceramic materials of the invention preferably have a large piezoelectric output constant (g₃₃), as well as a large piezoelectric strain constant. The piezoelectric ceramic materials according to the invention may have g₃₃ of 18 X 10⁻³ to 21 X 10⁻³ V·m/N. Such piezoelectric ceramic materials are applicable to the production of active or passive elements.

The piezoelectric characteristics of piezoelectric ceramic materials depend heavily upon even slight differences in the amounts of components contained in the materials. That is, even when a plurality of piezoelectric ceramic materials contain the same elements, the piezoelectric characteristics differ in accordance with the amounts of elements and the proportions of the elements. The piezoelectric ceramic materials described in Japanese Patent Publication (*kokoku*) No. 4-60073, for example, contains the same elements as those in the piezoelectric ceramic materials of the invention, but the proportions of the elements contained in the former materials differ from those of the elements contained in the latter materials. Particularly, the amount of Ba contained in the materials of the invention is greater than that of Ba contained in the material described in the above publication, i.e. the amount of barium titanate contained in the materials of the invention is greater than that of barium titanate contained in the materials described in the above publication. In addition, the materials of the invention differ from the materials described in the above publication in that the materials of the invention contain Na and Bi in almost the same amounts.

The following Examples illustrate the invention.

### EXAMPLES

### (1) Production of piezoelectric ceramic materials and piezoelectric elements

Commercially available BaCO₃ powder, Bi₂O₃ powder, Na₂CO₃ powder and TiO₂ powder were weighed so as to attain the compositional proportions shown in Table 1. These powders and ethanol were placed in a ball mill, and then wet-mixed for 15 hours. The resultant slurry was dried in a hot-water bath, and then calcined in air at 800°C for two hours. Subsequently, the calcined product, an organic binder, a dispersant, and ethanol were placed in a ball mill, and then wet-mixed for a further 15 hours. Subsequently, the resultant slurry was dried in a hot-water bath for granulation, and the granules were formed into a column-shaped product having a diameter of 5 mm and a length of 15 mm, through uniaxial pressing at 1 GPa. Thereafter, the product was subjected to cold isostatic pressing (CIP) at 15 Gpa, and the resultant product was fired in air at 1,050-1,250°C for two hours, thereby producing a piezoelectric ceramic material. In Table 1, samples marked with * fall outside the scope of the invention.

**TABLE 1**

| | | Composition | x | a | Bi/Na |
|---|---|---|---|---|---|
| Examples | * 1 | Bi_{0.500}Na_{0.500}TiO₃ | 0.000 | 1.00 | 1.000 |
| | 2 | Ba_{0.090}Bi_{0.455}Na_{0.455}TiO₃ | 0.090 | 1.00 | 1.000 |
| | 3 | Ba_{0.210}Bi_{0.395}Na_{0.395}TiO₃ | 0.210 | 1.00 | 1.000 |
| | 4 | Ba_{0.240}Bi_{0.380}Na_{0.380}TiO₃ | 0.240 | 1.00 | 1.000 |
| | 5 | Ba_{0.300}Bi_{0.350}Na_{0.350}TiO₃ | 0.300 | 1.00 | 1.000 |
| | 6 | Ba_{0.420}Bi_{0.290}Na_{0.290}TiO₃ | 0.420 | 1.00 | 1.000 |
| | 7 | Ba_{0.480}Bi_{0.260}Na_{0.260}TiO₃ | 0.480 | 1.00 | 1.000 |
| | 8 | Ba_{0.510}Bi_{0.245}Na_{0.245}TiO₃ | 0.510 | 1.00 | 1.000 |
| | *9 | Ba_{0.005}Bi_{0.495}Na_{0.500}TiO₃ | 0.005 | - | 0.990 |

The upper and lower surfaces of each of the piezoelectric ceramic materials were subjected to polishing. Then, a silver paste was applied to both surfaces by screen printing and baking to form electrodes. Thereafter, the electrodes were subjected to polarization treatment in insulating oil (silicone oil) maintained at 10-200°C, through application of a direct current of 3-7 kV/mm for 30 minutes, to produce piezoelectric elements.

### (2) Measurement of piezoelectric characteristics

The piezoelectric strain constant (d₃₃^{20°C}) and the piezoelectric output constant (g₃₃) of each of the piezoelectric elements produced above were measured according to EMAS-6100 in a thermostatic chamber maintained at 20°C, by use of an impedance analyzer (model: 4149A, product of Hewlett Packard). The results are shown in Table 2.

Similarly, the piezoelectric strain constant (d₃₃^{80°C}) of the piezoelectric elements was measured in a thermostatic chamber maintained at 80°C. The d₃₃^{80°C} and the d₃₃^{20°C} were substituted into formula (1), to calculate d₃₃t. The results are shown in Table 2. In Table 2, samples marked with * fall outside the scope of the invention.

**TABLE 2**

| | | d₃₃^{20°C} (X 10⁻¹² C/N) | d₃₃t (%/°C) | g₃₃ (X 10⁻³ V·m/N) |
|---|---|---|---|---|
| Examples | *1 | 73 | 0.31 | 17 |
| | 2 | 159 | 0.33 | 18 |
| | 3 | 131 | 0.12 | 21 |
| | 4 | 118 | 0.08 | 21 |
| | 5 | 111 | 0.09 | 20 |
| | 6 | 103 | 0.09 | 21 |
| | 7 | 92 | 0.11 | 20 |
| | 8 | 76 | 0.33 | 17 |
| | *9 | 64 | 0.30 | 15 |

It is apparent from Table 2 that the piezoelectric elements of Examples 2 to 8 (i.e., the elements containing the materials of the invention), in which x falls within a range of 0.05 to 0.5, have large piezoelectric strain constants (76 X 10⁻¹² to 159 X 10⁻¹² C/N). Particularly, in the piezoelectric elements of Examples 3 to 7, since x falls within a range of 0.2 to 0.5, the temperature coefficient is as small as 0.08 to 0.12 %/°C (i.e., temperature dependence is low), and the piezoelectric strain constant is as large as 92 X 10⁻¹² to 131 X 10⁻¹² C/N. In contrast, in the element of Example 9, the piezoelectric strain constant is small, since the molar ratio Bi/Na is 0.990.

The piezoelectric ceramic materials of the invention may contain Li and K as components. Li or K may assume any form in the ceramic materials but are preferably substituted for some Na atoms contained in BNT. The piezoelectric ceramic materials of the invention may contain, in addition to the above components, other components or unavoidable impurities, so long as they do not substantially affect the piezoelectric characteristics of the ceramic materials.

## Claims

1. A piezoelectric ceramic material containing Ba, Bi, Na, Ti and O and which on a molar basis satisfies 0.990 < Bi/Na ≤ 1.01 and Ba/Bi = 2x/(a-x) in which 0.99 ≤ a ≤ 1.01 and 0 < x < a.

2. A piezoelectric ceramic material according to claim 1, which is represented by the formula xBaTiO₃-(a-x)(Bi_{b}Na_{c})TiO₃ in which b and c satisfy 0.990 < b/c ≤ 1.01.

3. A piezoelectric ceramic material according to claim 2, wherein x is from 0.05 to 0.5, inclusive.

4. A piezoelectric ceramic material according to any one of claims 1 to 3 having a piezoelectric strain constant at 20°C (d₃₃^{20°C}), as measured according to EMAS-6100, of 100 X 10⁻¹² C/N or more, and a piezoelectric strain constant temperature coefficient (d₃₃t) of 0.15 %/°C or less, the temperature coefficient (d₃₃t) being calculated from d₃₃^{20°C} and the piezoelectric strain constant at 80°C (d₃₃^{80°C}) by the formula d₃₃t (%/°C) = (d₃₃^{80°C} - d₃₃^{20°C})/{(80°C-20°C) X d₃₃^{20°C}} X 100.

5. A piezoelectric ceramic material according to claim 4, wherein 105 X 10⁻¹² < d₃₃^{20°C} (C/N) < 150 X 10⁻¹² and 0.05 < d₃₃t (%/°C) < 0.14.
